# EUROPÄISCHE PATENTSCHRIFT

(11) **EP 1 343 119 B1**
(45) Veröffentlichungstag und Bekanntmachung des Hinweises auf die Patenterteilung: **09.04.2008**
(21) Anmeldenummer: 02027163.1
(22) Anmeldetag: 05.12.2002
(51) Int. Cl.: G06T 17/00, G06F 17/50, G06T 15/50

(54) **Verfahren und Vorrichtung zur Ermittlung von Sehfeldern**
Method and device for determining the field of view
Méthode et dispositif pour déterminer d'un champ de vision

(30) Priorität: 06.03.2002 DE 10209962
(43) Veröffentlichungstag der Anmeldung: 10.09.2003
(73) Patentinhaber: Rheinmetall Landsysteme GmbH, 24107 Kiel (DE)
(72) Erfinder: Hass, Frank, 24235 Wendtorf (DE)
(74) Vertreter: Dietrich, Barbara

(56) Entgegenhaltungen:
- DE-A- 19 816 054
- US-A- 5 096 281
- CARFAGNI M ET AL: "A rendering-based CAD method for the design and testing of rearview mirrors" FROM GEOMETRIC MODELING TO SHAPE MODELING. IFIP TC5 WG5.2 SEVENTH WORKSHOP ON GEOMETRIC MODELING: FUNDAMENTALS AND APPLICATIONS, FROM GEOMETRIC MODELING TO SHAPE MODELING. IFIP TC5 WG5.2 SEVENTH WORKSHOP ON GEOMETRIC MODELING: FUNDAMENTALS AND APPLIC, Seiten 115-126, XP002242323 2002, Norwell, MA, USA, Kluwer Academic Publisher, USA ISBN: 0-7923-7635-8
- PATENT ABSTRACTS OF JAPAN vol. 2000, no. 22, 9. März 2001 (2001-03-09) & JP 2001 125948 A (JEKKU:KK), 11. Mai 2001 (2001-05-11)
- MCCARTY W D ET AL: "A virtual cockpit for a distributed interactive simulation" IEEE COMPUTER GRAPHICS AND APPLICATIONS, JAN. 1994, USA, Bd. 14, Nr. 1, Seiten 49-54, XP000051108 ISSN: 0272-1716
- STORK A.; RIX J.: 'Combining ergonomic and field-of-view analysis using virtual humans' CTS CONFERENCE 1999; INTERNATIONAL SYMPOSIUM ON AUTOMATIVE TECHNOLOGY AND AUTOMATION 1999, Seiten 493 - 500
- ANONYM: 'Auszüge aus: Proposal for ECC 71/127: ...indirect vision ... of rear-view mirrors' EU DIRECTIVE ECC/71/127 07 Januar 2002,

## Beschreibung

Die Erfindung bezieht sich auf ein Verfahren und eine Vorrichtung zur Ermittlung von Sehfeldern für die Darstellung von Sehfeldern in horizontaler und vertikaler Ausdehnung, die ein Gütekriterium für die Beurteilung der Sichtverhältnisse aus einem Fahrzeug, insbesondere für Insassen unter Panzerschutz darstellen.

Da die Sicht durch ein Fahrzeugfenster, beispielsweise für den Fahrer, sehr unterschiedlich sein kann und dabei durch Karrosserieteile beeinträchtigt wird, zum Beispiel durch einen Fensterholm, ist es bekannt, Hilfsmittel einzusetzen, mit denen nicht unmittelbar einsehbare Bereiche in der Umgebung des Fahrzeuges überwacht werden können. Ein derartiges Hilfsmittel kann dabei ein Kamerasystem sein, wie in DE 198 16 054 A1 offenbart.

Die natürliche Sicht aus einem Fahrzeug ohne elektronische Hilfsmittel, insbesondere einem militärischen gepanzerten Fahrzeug, ist naturgemäß von großer Bedeutung für die Effektivität eines Fahrzeugsystems und das Überleben der Besatzung im Einsatzfall. Deshalb möchte man auch schon in der Entwicklungsphase genauer wissen, ob die Sichtverhältnisse aus einem zu entwickelnden Fahrzeug ausreichend gegeben sind. Aber auch die Sicht mit Hilfsmitteln, zum Beispiel Videokamera, möchte man in gleicher Weise überprüfen können.

So werden die Erzeugung eines entsprechenden Bodendiagramms als auch vertikaler Sehfelder in der Praxis bereits zum Stadium der Konstruktion angestrebt.

Nach einem internen Stand der Technik ist bekannt, die Sichtdiagramme zeichnerisch geometrisch zu ermitteln und darzustellen, wobei auch Rechengeräte, die nach Eingabe entsprechender Daten und ausgehend von einem Augenpunkt an einer vorgegebenen Sichtöffnung am Fahrzeug den Strahlengang der Sichtstrahlen abprüfen und eine Grafik als Bodensichtdiagramm (Sicht auf den Boden) ausgeben.

Eine Vorrichtung sowie ein Verfahren zur Erstellung eines virtuellen Anlagenmodells ist aus der DE 198 32 974 A1 bekannt. Dabei wird ein reelles Anlagenmodell virtuell in 3D- Format nachgebildet.

Die Nachteile dieser Lösungen sind der große Arbeitsaufwand für die Erstellung der Diagramme, da alles manuell bearbeitet wird bzw. Konstruktionsdaten aus Zeichnungen oder CAD-Systemen (Computer Aided Design) in einen sogenannten Sehfeldrechner eingegeben werden müssen.

In Carfagni M et al.: "A rendering-based CAD method for the design and testing of rearview mirrors", publiziert in Norwell. MA, USA Kluwer Academic Publisher, USA, ISBN: 0-7923-7635-8, 2002, Seiten 115 - 126 wird ein CAD-Programm beschrieben, mit dessen Hilfe in der speziellen Ausführung ein Rückspiegel optimiert werden soll. Dieses basiert auf dem Prinzip der Reflexion von Strahlen an einem Spiegel. Sogenannte Sichtdiagramme können damit nicht erzeugt werden. Dieser Beitrag wurde bereits früher publiziert auf "IFIP Seventh Workshop on Geometric Modeling : Fundamentals and Applications", am 2.-4. okt. 2000 in Parma, Italien.

In "Combining ergonomic and field-of-view analysis using virtual humans", Quelle: CTS Conference 1999, wird angeführt, dass virtuelle Menschen bei der ergonomischen Innenraumgestaltung eines Fahrzeuges genutzt werden. Dazu wird nicht nur die Position der Insassen betrachtet sondern virtuell auch von außen auf das Fahrzeug geschaut.

Die Erfindung stellt sich die Aufgabe, ein Verfahren und eine Vorrichtung zur einfachen und Darstellung von Sicht- bzw. Sehfeldern bzw. -diagrammen anzugeben, um der allgemeinen Forderung nach Sichtfelddiagrammen für die Bodensicht und vertikale Sehfelder zu entsprechen.

Diese Aufgabe wird durch die Merkmale des Anspruchs 1 sowie des Anspruchs 3 gelöst.

Die Erfindung basiert auf der Idee, eine virtuelle und damit automatische Darstellung anzugeben. Dabei werden bekannte Daten eines Fahrzeugs eines CAD-Systemes in 3D-Format genutzt, diese in einen simulierten Messraum eingebunden und in diese 3D-Darstellung ein imaginären Lichtpunkt (Lichtquelle) anstelle eines Augenpunktes eingebracht, um aus Sicht dieses Punktes die gewünschten Sehfelder bzw. Sichtfelder in horizontaler und/oder vertikaler Ausdehnung als solches mittels eines Rechners zu simulieren und diese zudem auf einem Sichtgerät graphisch darzustellen. Entsprechende Software dazu sind bekannt, wie z.B. das IPA, das Ray-tracing usw. Diese Ausdehnungen werden als Bodensichtdiagramm (Polardiagramm für die horizontale Bodensicht) und als Polardiagramm für die vertikalen Sehfelder aufgezeichnet. Als Simulationsrechner wird ein Rechnergerät oder Personalcomputer aus dem Bereich des Computer Aided Design (CAD) eingesetzt.

Erfindungsgemäß wird also das Fahrzeugmodell, das als Volumenmodell elektronisch mittels Rechner dargestellt ist, in den virtuellen Messraum gestellt und auf dem Sichtgerät sichtbar gemacht. Jedes Fahrzeug, das so als 3D-Modell elektronisch erzeugt wird, kann in den Messraum gestellt werden.

Sodann wird der Augenpunkt eines Insassen im Fahrzeug als virtuelles Punktlicht elektronisch dargestellt und ein Bodensichtdiagramm mittels eines Schattenwurfs des Punktlichts auf einem Messboden erzeugt. Dabei wird der Grenzabstand, ab den ein Bediener Bodensicht hat, in Metern auf dem Messboden angezeigt.

Zur Ermittlung des vertikalen Sehfeldes wird das CAD-Modell des Fahrzeugs nicht wie bei der Ermittlung des Bodensichtdiagramms auf den ebenen Messboden sondern in die Mitte eines vorzugsweise parabelförmigen Messkörpers gestellt. Auf diesem Messkörper werden (Licht-)Strahlen abgebildet, die aufgrund ihres Austrittswinkels nie den Boden erreichen können.

Weitere Vorteile ergeben sich aus den Unteransprüchen.

In einer ersten bevorzugten Ausführung sind der virtuelle Messboden und der virtuelle Messkörper in einem virtuellen Messraum zusammengefasst. Dies hat den Vorteil, dass das Ausrichten der Lichtquellen für vertikale Sehfelder und Bodensehfelder (horizontale Ausrichtung) nur einmal durchgeführt werden muss.

Der virtuelle Messraum, der mittels Rechnersystem simuliert wird und in den das Fahrzeug als 3D- Modell nachgestaltet eingebracht ist, weist zum 3D-Modell vorzugsweise ein Verhältnis von 1:1 auf.

Der Messboden ist mit konzentrischen Messmarkierungen um einen Mittelpunkt versehen und vorzugsweise in mehrere Sektoren gleichmäßig um den Mittelpunkt aufgeteilt, um die Winkel des Polardiagramms der Bodensicht direkt ablesen zu können. Diese konzentrischen Messmarkierungen können Ringe mit Radienangaben sein.

Der Messkörper ist dreidimensional und radialsymmetrisch um einen Mittelpunkt ausgebildet und mit einem parabelförmigen Querschnitt und mehreren Markierungsringen auf der dem Mittelpunkt zugewandten Messkörperfläche versehen, wobei die Parabelform so ausgebildet ist, dass die Markierungsringe in einem geeigneten Abstand zueinander angeordnet sind und gleichzeitig eine gleichförmige Winkeldifferenz bei Verbinden von Ringpunkten auf benachbarten und verschiedenen Ringen mit dem Mittelpunkt mittels Messstrahlen und bei Messung des Winkels zwischen zwei Strahlen anzeigen.

In Weiterführung der Erfindung ist der das zu messende Fahrzeug umgebende Messkörper im Querschnitt so geformt, dass konzentrische Ringe als Messmarkierungen auf der dem Fahrzeug zugewandten Fläche des Messkörpers mit bei gleichbleibenden Sprüngen der Winkelangaben auch gleichbleibende Sprünge im zugeordneten Radius vom Mittelpunkt aufweisen, um Verzerrungen zu vermeiden, wobei die innere Querschnittkurve entsprechend einer Tangensfunktion ausgestaltet ist.

Um fallweise auch aus der Waagerechten nach unten gerichtete Winkel als negative Elevationswinkel vermessen zu können, ist der Messkörper in Weiterführung der Erfindung in seinem Zentrum, in dem das zu vermessende Fahrzeug und entsprechend der Augen- und Lichtpunkt angeordnet sind, gegenüber der Umgebung des Zentrums erhöht.

Der Messkörper ist unter dem Fahrzeug vorzugsweise ausgespart und das Fahrzeug einschließlich des Augen- und Lichtpunkts im Zentrum des Messkörpers frei im Raum schwebend, um störende Schatten in unmittelbarer Nähe des Fahrzeugs zu vermeiden.

Die vorzugsweise punktförmige Lichtquelle wird in Simulation der Sehfelder vorzugsweise in die vertikale Drehachse einer Rohrwaffe oder einer anderen richtbaren Waffe und mit einem Strahlengang durch die Rohrseelenachse gesetzt, um Störkonturen bei der Rundumdrehung der Waffe zu ermitteln, wobei auch aus der Waagerechten nach unten gerichtete Winkel als Depressionswinkel ermittelt werden.

Weiterhin ist die punktförmige Lichtquelle im Messkörper vorzugsweise genau auf den Mittelpunkt des Messkörpers ausgerichtet, damit geradlinige Störkonturen des Fahrzeugs auf der gewölbten Projektionsfläche ebenso gerade abgebildet werden.
Als Ausrichthilfen im Messkörper werden vorzugsweise halbdurchsichtige Wände eingesetzt. Dabei wird zunächst das Fahrzeug und anschließend ein Augen- oder Lichtpunkt auf die Ausrichthilfen ausgerichtet, damit Lichtpunkte auch in von außen undurchsichtigen Fahrzeugen positioniert werden können, ohne die Koordinaten des Punktes kennen zu müssen.

Als punktförmige Lichtquellen werden Lichtquellen mit begrenztem und definiertem Lichtkegel eingesetzt, um begrenzte Ausblickwinkel einer Fenster- ober Optiköffnung aufzuzeigen.

Vorteilhaft ist auch, dass im virtuellen Modell Lichtquellen mit unterschiedlicher Lichtfarbe verwendet werden können, um so bei Polardiagrammen Sichtmöglichkeiten mehrerer Personen im Fahrzeug die Einzelsehfelder anhand der einer Person zugeordneten Farbe zu unterscheiden.

Der Messboden und -körper kann vorzugsweise mit virtuell körperlich eingefrästen Messringen und Maßen anstelle von aufgezeichneten Ringen und Maßen und fallweise die Vertiefung der Einfräsung mit einer kontrastreichen Farbe versehen werden, so dass die Erkennbarkeit der Ringe und Maße wesentlich verbessert wird und dieses nicht abhängig ist von der jeweiligen Licht-/Schatten-Situation.

Ein Vorteil des erfindungsgemäßen Vorgehens ist die zeitsparende Sehfeldermittlung und -prüfung bei Fahrzeugen, bei denen die Konstruktionsdaten als 3D- oder Volumenmodell vorliegen.

Ein weiterer Vorteil ergibt sich dadurch, daß nach Einbringen des Fahrzeugmodells in den virtuellen Messraum und Setzen eines Lichtpunktes (Punktlicht) als Augenpunkt an verschiedene interessierende Stellen im Fahrzeug Bodensichtdiagramme oder Polardiagramme schnell erstellt werden können.
Zudem können Änderungen am Fahrzeugmodell, dem noch nicht gebauten Fahrzeug, sofort auf ihre Auswirkung auf Sichtfelder überprüft werden.

Anhand eines Ausführungsbeispieles mit Zeichnungen soll die Erfindung näher erläutert werden.

Es zeigen in schematischer Darstellung
- Fig. 1: ein Schema mit Messboden und Fahrzeug,
- Fig. 2: einen Querschnitt des Messkörpers,
- Fig. 3: ein Beispiel für ein Bodensichtdiagramm,
- Fig. 4: ein Beispiel für ein vertikales Sehfeld,
- Fig. 5: ein Fahrzeug im virtuellen Messraum.

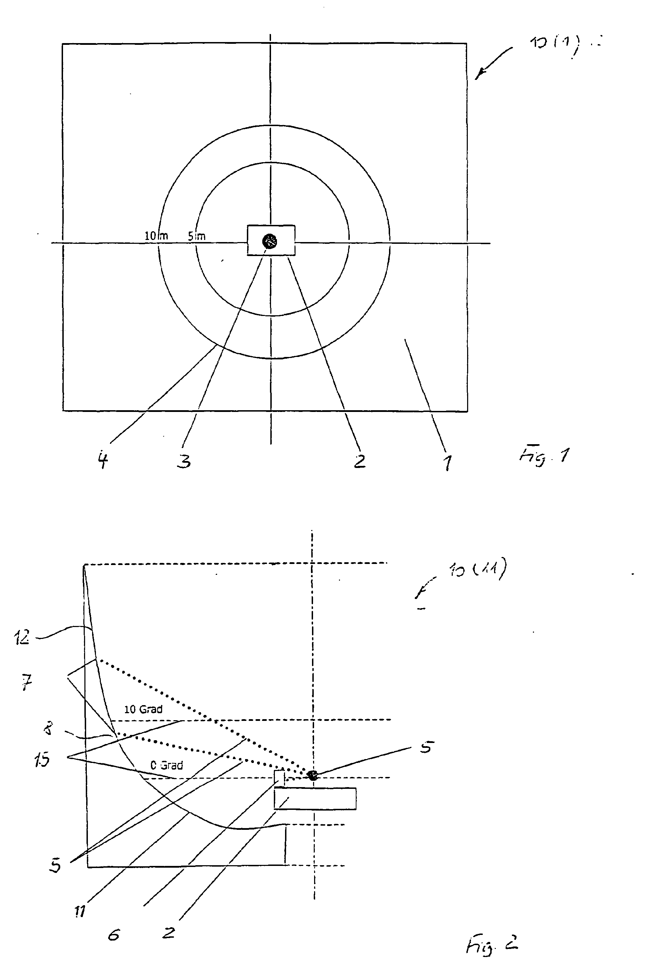

In Fig. 1 steht auf einer ebenen Bodenfläche 1 als Messfläche eines virtuell geschaffenen Messraumes 10 ein angedeutetes Fahrzeug 2 (im 3D-Format) im Zentrum der Fläche 1. Eine virtuelle Lichtquelle 3 bzw. ein Lichtpunkt als Augenpunkt eines nicht näher dargestellten Betrachters befindet sich auf dem Fahrzeug 2. Messmarkierungen 4 sind in Form von konzentrischen Ringen um die Lichtquelle 3 auf der Messfläche 1 eingezeichnet und gleichmäßig voneinander beabstandet.

Der Messraum 10 umfasst auch einen Messkörper 11 für die Erstellung vertikaler Sichtbilder (wird noch ausgeführt).

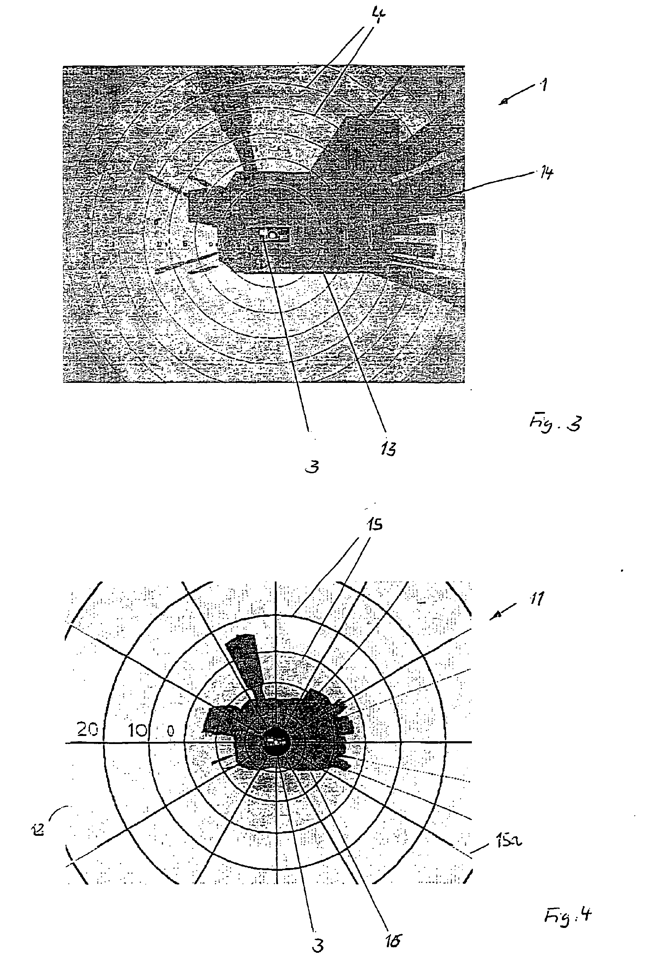

In Figur 2 ist der Augenpunkt und gleichzeitig Mittelpunkt des Messkörpers 11 oberhalb eines angedeuteten Fahrzeugs 2 als Ausgangspunkt von Lichtstrahlen 5 der Lichtquelle 3 dargestellt. Die Lichtstrahlen 5 werden von einem Gegenstand 6 am Fahrzeug 2 behindert oder vorbeigelassen. Die Lichtstrahlen 5 treffen an Punkten 7 auf eine Projektionsfläche 12 des Messkörpers 11 auf bzw. bildet sich dort ein Schattenriss 8 des dort abgebildeten Gegenstands 6. Messmarkierungen 15, die zum Beispiel die Winkel 0 und 10 Grad rundherum auf der Projektionsfläche 12 markieren, geben zusammen mit einem Schattenwurf 16 das Polardiagramm des vertikalen Sehfeldes des angenommenen Augenpunktes 3 über 360 Grad um das Fahrzeug 2 herum an (Fig. 4).

In Fig. 3 ist ein Bodensichtdiagramm gezeigt mit dem Fahrzeug 2 (hier ein Militärfahrzeug) in der Mitte der Projektionsebene und den konzentrischen Messmarkierungen 4 um das Fahrzeug 2 herum. Deutlich erkennbar die Kontur der Ausblendungen bzw. des Schattenwurfs 13. Die abgeschattete Fläche 14 innerhalb des Schattenwurfs 13 stellt die Bodenfläche 1 dar, die mit dem angenommenen Augenpunkt 3 am Fahrzeug 2 nicht eingesehen werden kann.

In Figur 4 ist eine zu Figur 3 vergleichbare Darstellung des vertikalen Sehfeldes gezeigt. Konzentrische Messmarkierungen 15, die hier einen vertikalen Winkel darstellen, geben zusammen mit dem Schattenwurf 16 an, ab welchem Höhenwinkel freie Sicht nach oben oder in einem Winkelbereich nach oben gegeben ist.

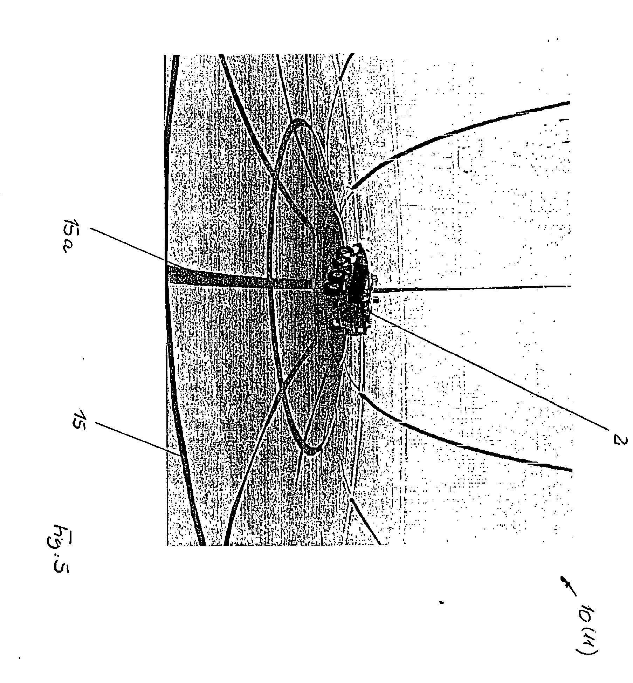

In Figur 5 ist das Fahrzeug 3 beispielhaft im virtuellen Messraum 10 mit umlaufenden 15 oder radialen 15a Messmarkierungen dargestellt. Zur Ermittlung des vertikalen Sehfeldes wird das CAD-Modell des Fahrzeugs 2 nicht wie bei der Ermittlung des Bodensichtdiagramms auf einen ebenen Messboden 1 sondern in die Mitte des parabelförmigen Messraum 10 bzw. -körpers 11 gestellt. Anschließend werden, wie in Fig. 2 aufgezeigt, vom angenommenen Augenpunkt 3 aus mittels virtuellem Verfolgen der Sichtstrahlen 6 die Winkel des Schattenwurfs 16 auf die Projektionsfläche 12 am Messkörper 11 festgestellt. Von oben betrachtet, ergibt sich das Polardiagramm.

### Bezugszeichenliste

- 1: Bodenfläche / Messfläche
- 2: Fahrzeug
- 3: Lichtquelle/ Lichtpunkt - Augenpunkt
- 4: Messmarkierungen
- 5: Lichtstrahlen
- 6: Gegenstand
- 7: Punkte
- 8: Schattenriss
- 13: Schattenwurf

- 10: Messraum

- 11: Messkörper
- 12: Projektionsfläche des Messkörpers

- 14: abgeschattete Fläche
- 15 , 15a: Messmarkierungen
- 16: Schattenwurf

## Patentansprüche

1. Verfahren zur Erzeugung von Sehfeldern zur Ermittlung und Aufzeichnung von Störkonturen und toten Zonen an einem Fahrzeug (2), wobei
- das Fahrzeug (2) als 3- dimensionales CAD- Modell simuliert wird, wobei
- wenigstens eine Lichtstrahlen (5) aussendende Lichtquelle (3) als Lichtpunkt in oder am Fahrzeug (2) positioniert und **dadurch gekennzeichnet, dass** mit dessen Hilfe
- ein horizontaler Schattenwurf (13) als Schatten des Fahrzeugs (2) als Bodensichtdiagramm auf eine Bodenfläche bzw. Messboden (1) und
- ein vertikaler Schattenwurf (16) als Schatten des Fahrzeugs (2) als vertikales Sehfeld auf einem das Fahrzeug (2) umgebenen Messkörper (11) projiziert wird.

2. Verfahren nach Anspruch 1, **dadurch gekennzeichnet, dass** Lichtquellen (3) mit unterschiedlicher Lichtfarbe verwendet werden, um so bei Polardiagrammen für die horizontale Bodensicht (Bodensichtdiagramm) und für die vertikalen Sehfelder bei mehreren Personen im Fahrzeug die Einzelsehfelder anhand der einer Person zugeordneten Farbe zu unterscheiden.

3. Vorrichtung zur Erzeugung von Sehfeldern zur Ermittlung und Aufzeichnung von Störkonturen und toten Zonen an einem Fahrzeug (2), mit
- Mitteln, um das Fahrzeug (2) als 3- dimensionales CAD- Modell zu simulieren, wobei
- wenigstens eine Lichtstrahlen (5) aussendende Lichtquelle (3) als Lichtpunkt in oder am Fahrzeug (2) positioniert ist, **dadurch gekennzeichnet, dass** mit dessen Hilfe
- ein horizontaler Schattenwurf (13) als Schatten des Fahrzeugs (2) als Bodensichtdiagramm auf eine Bodenfläche bzw. Messboden (1) und
- ein vertikaler Schattenwurf (16) als Schatten des Fahrzeugs (2) als vertikales Sehfeld auf einem das Fahrzeug (2) umgebenen Messkörper (11) projiziert wird.

4. Vorrichtung nach Anspruch 3, **dadurch gekennzeichnet, dass** die Bodenfläche (1) und der Messkörper (11) in einem virtuellen Messraum (10) zusammengefasst sind.

5. Vorrichtung nach Anspruch 3 oder 4, **dadurch gekennzeichnet, dass** der Messraum (10) zum Fahrzeug ein Verhältnis von 1:1 aufweist.

6. Vorrichtung nach einem der Ansprüche 3 bis 5, **dadurch gekennzeichnet, dass** der ebene Messboden (1) mit konzentrischen Messmarkierungen (4) um einen Mittelpunkt versehen ist.

7. Vorrichtung nach einem der Ansprüche 3 bis 6, **dadurch gekennzeichnet, dass** der Messboden (1) in mehrere Sektoren gleichmäßig um den Mittelpunkt aufgeteilt ist.

8. Vorrichtung nach einem der Ansprüche 3 bis 7, **dadurch gekennzeichnet, dass** der Messkörper (11) dreidimensional und radialsymmetrisch um einen Mittelpunkt ausgebildet ist, einen parabelförmigen Querschnitt mit mehreren Markierungsringen (15) auf der dem Mittelpunkt zugewandten Messkörperfläche (12) aufweist, wobei die Parabelform so ausgebildet ist, dass die Markierungsringe (15) in einem geeigneten Abstand zueinander angeordnet sind und gleichzeitig eine gleichförmige Winkeldifferenz bei Verbinden von Ringpunkten auf benachbarten und verschiedenen Ringen (15) mit dem Mittelpunkt mittels Messstrahlen und bei Messung des Winkels zwischen zwei Strahlen anzeigen.

9. Vorrichtung nach Anspruch 8, **dadurch gekennzeichnet, dass** der das zu messende Fahrzeug (2) umgebende Messkörper (11) im Querschnitt so geformt ist, dass konzentrische Ringe (15) als Messmarkierungen auf der dem Fahrzeug (2) zugewandten Fläche (12) des Messkörpers (11) mit bei gleich bleibenden Sprüngen der Winkelangaben auch gleich bleibende Sprünge im zugeordneten Radius vom Mittelpunkt aufweisen und ein innere Querschnittkurve entsprechend einer Tangensfunktion ausgestaltet ist.

10. Vorrichtung nach Anspruch 8 oder 9, **dadurch gekennzeichnet, dass** der Messkörper (11) in seinem Zentrum, in dem das zu vermessende Fahrzeug (2) und entsprechend ein Augen- und Lichtpunkt angeordnet sind, gegenüber der Umgebung des Zentrums erhöht ist.

11. Vorrichtung nach einem der Ansprüche 8 bis 10, **dadurch gekennzeichnet, dass** der Messkörper (11) unter dem Fahrzeug (2) ausgespart ist und das Fahrzeug (2) einschließlich des Augen- bzw. Lichtpunkts (3) im Zentrum des Messkörpers (11) frei im Raum schwebt.

12. Vorrichtung nach einem der Ansprüche 3 bis 11, **dadurch gekennzeichnet, dass** die punktförmige Lichtquelle (3) im Messraum (10) genau auf den Mittelpunkt des Messraumes (10) ausgerichtet ist.

13. Vorrichtung nach einem der oben genannten Ansprüche 3 bis 12, **dadurch gekennzeichnet, dass** halbdurchsichtige Wände als Ausrichthilfen im Messkörper (11) eingesetzt werden, auf die zunächst das Fahrzeug (2) und anschließend ein Augen- oder Lichtpunkt (3) auf die Ausrichthilfen ausgerichtet wird.

14. Vorrichtung nach einem der oben genannten Ansprüche 3 bis 13, **dadurch gekennzeichnet, dass** die Lichtquelle (3) einen begrenzten und definierten Lichtkegel besitzt.

15. Vorrichtung nach einem der oben genannten Ansprüche 3 bis 14, **dadurch gekennzeichnet, dass** im virtuellen Modell Lichtquellen (3) mit unterschiedlicher Lichtfarbe verwendet werden.

16. Vorrichtung nach einem der oben genannten Ansprüche 3 bis 15, **dadurch gekennzeichnet, dass** der Messraum (10) mit virtuell körperlich eingefrästen Messringen (4, 15) und Maßen und die Vertiefung der Einfräsung mit einer kontrastreichen Farbe versehen werden.

17. Vorrichtung nach einem der Ansprüche 3 bis 16, **dadurch gekennzeichnet, dass**
- die punktförmige Lichtquelle (2) in die vertikale Drehachse einer Rohrwaffe oder einer anderen richtbaren Waffe und
- mit einem Strahlengang durch die Rohrseelenachse gesetzt wird.

18. Vorrichtung nach einem der Ansprüche 3 bis 17, **dadurch gekennzeichnet, dass** als Rechner ein Rechengerät oder Personalcomputer aus dem Bereich des Computer Aided Design (CAD) eingesetzt wird.

## Claims

1. Method for generating fields of view for determining and recording interference contours and dead zones adjacent to a vehicle (2),
- the vehicle (2) being simulated as a three-dimensional CAD model, in which
- at least one light source (3) emitting light beams (5) is positioned as a light point in or on the vehicle (2), **characterized in that**, by means of, said light source (3)
- a horizontal shadow (13) cast as the shadow of the vehicle (2) is projected as a ground visibility diagram onto a base area or measurement base (1) and
- a vertical shadow (16) cast as the shadow of the vehicle (2) is projected as a vertical field of view onto a measuring body (11) surrounding the vehicle (2).

2. Method according to Claim 1, **characterized in that** light sources (3) having different light colours are used in order to distinguish between the individual fields of view when there are a number of people being in the vehicle, by means of the colour associated to each person in the case of polar diagrams for the horizontal ground visibility (ground visibility diagram) and for the vertical fields of view.

3. Device for generating fields of view for determining and recording interference contours and dead zones adjacent to a vehicle (2), having
- means to simulate the vehicle (2) as a three-dimensional CAD model, in which
- at least one light source (3) emitting light beams (5) is positioned as a light point in or on the vehicle (2), **characterized in that**, by means of, said light source (3)
- a horizontal shadow (13) cast as the shadow of the vehicle (2) is projected as a ground visibility diagram onto a base area or measurement base (1) and
- a vertical shadow (16) cast as the shadow of the vehicle (2) is projected as a vertical field of view onto a measuring body (11) surrounding the vehicle (2).

4. Device according to Claim 3, **characterized in that** the base area (1) and the measuring body (11) are combined in a virtual measuring space (10).

5. Device according to Claim 3 or 4, **characterized in that** the ratio of the measuring space (10) to the vehicle is 1:1.

6. Device according to one of Claims 3 to 5, **characterized in that** the planar measurement base (1) is provided with concentric measuring markings (4) around a centre point.

7. Device according to one of Claims 3 to 6, **characterized in that** the measurement base (1) is evenly divided into a plurality of sectors about the centre point.

8. Device according to one of Claims 3 to 7, **characterized in that** the measuring body (11) is formed three dimensionally and radially symmetrically about a centre point and has a parabolic cross section with a plurality of marking rings (15) on the measuring body surface facing the centre point, the parabolic cross section being formed such that the marking rings (15) are arranged at a suitable distance from one another and at the same time indicate a uniform angular difference when connecting ring points on adjacent and different rings (15) to the centre point by means of measuring beams and when measuring the angle between two beams.

9. Device according to Claim 8, **characterized in that** the measuring body (11) surrounding the vehicle (2) to be measured has a cross section such that concentric rings (15) as measuring markers on the surface (12) of the measuring body (11) facing the vehicle (2) have equal jumps in the angular readings and also in the associated radius from the centre point and an inner cross-sectional curve is formed according to a tangent function.

10. Device according to Claim 8 or 9, **characterized in that** the measuring body (11) is elevated in its centre, where the vehicle (2) to be measured and a corresponding eye and light point are arranged, compared to the surroundings of the centre.

11. Device according to one of Claims 8 to 10, **characterized in that** the measuring body (11) is hollow under the vehicle (2) and the vehicle (2) including the eye or light point (3) is freely suspended in space at the centre of the measuring body (11).

12. Device according to one of Claims 3 to 11, **characterized in that** the point light source (3) is aligned in the measuring body (10) exactly with the centre point of the measuring body (10).

13. Device according to one of Claims 3 to 12 mentioned above, **characterized in that** semitransparent walls are used as alignment aid in the measuring body (11), with respect to which first the vehicle (2) and then an eye or light point (3) are aligned.

14. Device according to one of Claims 3 to 13 mentioned above, **characterized in that** the light source (3) has a limited and well-defined light cone.

15. Device according to one of Claims 3 to 14 mentioned above, **characterized in that** light sources (3) with different light colours are used in the virtual model.

16. Device according to one of Claims 3 to 15 mentioned above, **characterized in that** the measuring space (10) is provided with virtually milled measuring rings (15), and the indentation of the milled recess is provided with a high-contrast colour.

17. Device according to one of Claims 3 to 16, **characterized in that**
- the point light source (2) is placed on the vertical axis of rotation of a tube weapon or another weapon that can be aimed and
- it is placed with a beam path through the barrel bore axis.

18. Device according to one of Claims 3 to 17, **characterized in that** a calculating unit or a personal computer from the field of computer aided design (CAD) is used as a computer.

## Revendications

1. Procédé pour générer des champs de vision pour déterminer et enregistrer des contours gênants et des angles morts sur un véhicule (2), le véhicule (2) étant simulé sous la forme d'un modèle de CAO tridimensionnel, au moins une source de lumière (3) émettant des rayons lumineux (5) étant placée sous la forme d'un point lumineux dans ou sur le véhicule (2), **caractérisé en ce qu'**à l'aide de celle-ci sont projetées une ombre projetée horizontale (13) sous la forme d'une ombre du véhicule (2) en tant que diagramme de visibilité du sol sur une surface au sol ou un sol de mesure (1) et une ombre projetée verticale (16) sous la forme d'une ombre du véhicule (2) en tant que champ de vision vertical sur un corps de mesure (11) qui entoure le véhicule (2).

2. Procédé selon la revendication 1, **caractérisé en ce que** sont utilisées des sources de lumière (3) ayant des couleurs lumineuses différentes afin de différencier ainsi avec des diagrammes polaires pour la vue du sol horizontale (diagramme de visibilité du sol) et pour le champ de vision vertical, en présence de plusieurs personnes dans le véhicule, les champs de vision individuels au moyen de la couleur associée à une personne.

3. Dispositif pour générer des champs de vision pour déterminer et enregistrer des contours gênants et des angles morts sur un véhicule (2), comprenant des moyens pour simuler le véhicule (2) sous la forme d'un modèle de CAO tridimensionnel, au moins une source de lumière (3) émettant des rayons lumineux (5) étant placée sous la forme d'un point lumineux dans ou sur le véhicule (2), **caractérisé en ce qu'**à l'aide de celle-ci sont projetées une ombre projetée horizontale (13) sous la forme d'une ombre du véhicule (2) en tant que diagramme de visibilité du sol sur une surface du sol ou un sol de mesure (1) et une ombre projetée verticale (16) sous la forme d'une ombre du véhicule (2) en tant que champ de vision vertical sur un corps de mesure (11) qui entoure le véhicule (2).

4. Dispositif selon la revendication 3, **caractérisé en ce que** la surface au sol (1) et le corps de mesure (11) sont regroupés dans un espace de mesure virtuel (10).

5. Dispositif selon la revendication 3 ou 4, **caractérisé en ce que** l'espace de mesure (10) présente un rapport de 1:1 par rapport au véhicule.

6. Dispositif selon l'une des revendications 3 à 5, **caractérisé en ce que** le sol de mesure plan (1) est doté de repères de mesure concentriques (4) autour d'un point central.

7. Dispositif selon l'une des revendications 3 à 6, **caractérisé en ce que** le sol de mesure (1) est divisé régulièrement en plusieurs secteurs autour du point central.

8. Dispositif selon l'une des revendications 3 à 7, **caractérisé en ce que** le corps de mesure (11) est réalisé en trois dimensions et avec une symétrie radiale autour d'un point central et présente une section transversale parabolique comprenant plusieurs anneaux de marquage (15) sur la surface de corps de mesure (12) qui fait face au point central, la forme parabolique étant configurée de telle sorte que les anneaux de marquage (15) sont disposés avec un espacement approprié les uns par rapport aux autres et indiquent simultanément une différence angulaire uniforme en reliant les points des anneaux (15) voisins et différents avec le point central au moyen de rayons de mesure et lors de la mesure de l'angle entre deux rayons.

9. Dispositif selon la revendication 8, **caractérisé en ce que** la configuration de la section transversale du corps de mesure, (11) qui entoure le véhicule (2) à mesurer est telle que des anneaux concentriques (15) faisant office de repères de mesure sur la surface (12) du corps de mesure (11) qui fait face au véhicule (2) présentent des sauts constants des indications angulaires et également des sauts constants dans le rayon correspondant par rapport au point central et une courbe de section transversale intérieure est formée conformément à une fonction de tangente.

10. Dispositif selon la revendication 8 ou 9, **caractérisé en ce que** le corps de mesure (11) est surélevé en son centre, là où est disposé le véhicule (2) à mesurer et par conséquent un point oculaire et lumineux, par rapport à l'environnement du centre.

11. Dispositif selon l'une des revendications 8 à 10, **caractérisé en ce que** le corps de mesure (11) est évidé sous le véhicule (2) et le véhicule (2) ainsi que le point oculaire ou lumineux (3) flotte librement dans l'espace au centre du corps de mesure (11).

12. Dispositif selon l'une des revendications 3 à 11, **caractérisé en ce que** la source de lumière ponctuelle (3) dans l'espace de mesure (10) est dirigée exactement sur le point central de l'espace de mesure (10).

13. Dispositif selon l'une des revendications 3 à 12, **caractérisé en ce que** des parois semi-transparentes sont utilisées comme aides à l'alignement dans le corps de mesure (11), sur lesquelles est tout d'abord aligné le véhicule (2) et ensuite un point oculaire ou lumineux (3).

14. Dispositif selon l'une des revendications 3 à 13, **caractérisé en ce que** la source de lumière (3) possède un cône lumineux limité et défini.

15. Dispositif selon l'une des revendications 3 à 14, **caractérisé en ce que** des sources de lumière (3) ayant des couleurs lumineuses différentes sont utilisées dans le modèle virtuel.

16. Dispositif selon l'une des revendications 3 à 15, **caractérisé en ce que** l'espace de mesure (10) est doté d'anneaux de mesure (4, 15) et de cotes fraisés physiquement virtuellement et l'empreinte du fraisage est doté d'une couleur fortement contrastée.

17. Dispositif selon l'une des revendications 3 à 16, **caractérisé en ce que** la source de lumière ponctuelle (2) est placée dans l'axe de rotation vertical d'une arme à canon ou d'une autre arme dirigeable et avec un trajet de rayon à travers l'axe de l'âme du canon.

18. Dispositif selon l'une des revendications 3 à 17, **caractérisé en ce que** le calculateur utilisé est un dispositif de calcul ou un ordinateur personnel dans le domaine de la conception assistée par ordinateur (CAO).
